# EUROPEAN PATENT SPECIFICATION

(11) **EP 0 822 450 B1**
(45) Date of publication and mention of the grant of the patent: **05.04.2000**
(21) Application number: 96202155.6
(22) Date of filing: 30.07.1996
(51) Int. Cl.: G03F 7/07, G03F 7/09

(54) **Imaging element for making an improved printing plate according to the silver salt diffusion transfer process**
Bildelement zur Herstellung einer verbesserten Druckplatte nach dem Silbersalz-Diffusionsübertragungsverfahren
Elément formateur d'images pour la production d'une plaque d'impression améliorée suivant le procédé diffusion-transfert de sel d'argent

(43) Date of publication of application: 04.02.1998
(73) Proprietor: AGFA-GEVAERT N.V., 2640 Mortsel (BE)
(72) Inventor: Coppens, Paul, Septestraat 27, 2640 Mortsel (BE); Vervloet, Ludo, Septestraat 27, 2640 Mortsel (BE)

(56) References cited:
- EP-A- 0 410 500
- EP-A- 0 570 041
- EP-A- 0 664 487

## Description

### 1. Field of the invention.

The present invention relates to an imaging element, for making improved lithographic printing plates according to the silver salt diffusion transfer process.

The present invention further relates to a method for making improved lithographic printing plates according to the silver salt diffusion transfer process.

### 2. Background of the invention.

The principles of the silver complex diffusion transfer reversal process, hereinafter called DTR-process, have been described e.g. in US-P-2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellent ink-receptive areas on a water-receptive ink-repellent background.

The DTR-image can be formed in the image receiving layer of a sheet or web material which is a separate element with respect to the photographic silver halide emulsion material (a so-called two-sheet DTR element) or in the image receiving layer of a so-called single-support-element, also called mono-sheet element, which contains at least one photographic silver halide emulsion layer integral with an image receiving layer in waterpermeable relationship therewith. It is the latter mono-sheet version which is preferred for the preparation of offset printing plates by the DTR method.

Two types of the mono-sheet DTR offset printing plate exist. According to a first type disclosed in e.g. US-P-4,722,535 and GB-1,241,661 a support is provided in the order given with a silver halide emulsion layer and a layer containing physical development nuclei serving as the image-receiving layer. After information-wise exposure and development the imaged element is used as a printing plate without the removal of the emulsion layer.

According to a second type of mono-sheet DTR offset printing plate a hydrophilic support, mostly anodized aluminum, is provided in the order given with a layer of physical development nuclei and a silver halide emulsion layer. After information-wise exposure and development the imaged element is treated to remove the emulsion layer so that a support carrying a silver image is left wich is used as a printing plate. Such type of lithographic printing plate is disclosed e.g. in US-P-3,511,656.

As for other printing plates it is required that the offset printing plates belonging to the second type of mono-sheet DTR offset printing plates have good printing properties e.g. a high printing endurance, good ink acceptance in the printing areas and no ink acceptance in the non-printing areas (no staining). It is furthermore desirable that the printing plate exhibits a high resolving power.

Offset printing plates belonging to the second type of mono-sheet DTR offset printing plates have in most respects good printing properties. However, these printing plates exhibit an unsatisfactory ink acceptance. So, there is still room for improvement of this type of printing plates.

### 3. Summary of the invention.

It is an object of the present invention to provide an imaging element for making offset printing plates according to the silver salt diffusion transfer process with a better ink acceptance.

It is another object of the present invention to provide a method for making offset printing plates with said imaging element having a better ink acceptance.

Further objects of the present invention will become clear from the description hereinafter.

According to the present invention there is provided an imaging element comprising in the order given on a hydrophilic surface of a support (i) an image receiving layer containing physical development nuclei, (ii) an intermediate layer and (iii) a photosensitive layer containing one or more silver halide emulsions being in water permeable relationship with said image receiving layer, characterized in that said intermediate layer comprises at least 0.08 mmole/m² of a bromide salt.

According to the present invention there is also provided a method for making an offset printing plate according to the silver salt diffusion transfer process comprising the steps of:
(a) image-wise exposing an imaging element according to the present invention,
(b) applying an aqueous alkaline solution to the imaging element in the presence of (a) developing agent(s) and (a) silver halide solvent(s),
(c) treating the imaging element to remove the layer(s) on top of said image receiving layer, thereby uncovering said silver image formed in said image receiving layer.

### 4. Detailed description of the invention.

Lithographic printing plates are obtained according to the DTR-process having good printing properties and a very good ink acceptance by using an imaging element comprising in the intermediate layer at least 0.08 mmole/m² of a bromide salt, preferably at least 0.12 mmole/m² of a bromide salt.

The bromide salt according to the invention is preferably an inorganic salt such as sodium or potassium bromide.

In one embodiment, the intermediate layer is a layer comprising hydrophobic polymer beads having an average diameter not lower than 0.2 µm and having been prepared by polymerization of at least one ethylenically unsaturated monomer. Preferably, said intermediate layer in dry condition comprises said hydrophobic polymer beads in an amount of up to 80% of its total weight. Further details are disclosed in EP-A-483415.

In another embodiment, the intermediate layer is a layer comprising particles of a water insoluble inorganic compound having a number average size not lower than 0.1 µm. Preferably, said intermediate layer comprises said water insoluble inorganic compound in an amount of at least 0.1 g/m². Further details are disclosed in EP-A-94203779.7

In still another embodiment, the intermediate layer is a layer comprising particles of an alkali insoluble non-polymeric organic compound having a melting point of at least 50°C, said particles having a number average size between 0.1 µm and 10 µm. Preferably, said intermediate layer comprises said alkali insoluble non-polymeric organic compound in an amount of at least 0.1 g/m². Further details are disclosed in EP-A-95201713.5

In still another embodiment, the intermediate layer is a layer comprising particles of an alkali insoluble polymeric organic compound obtainable by polycondensation, said particles having a number average size between 0.02 µm and 10 µm. Preferably, said intermediate layer comprises said alkali insoluble polymeric organic compound obtainable by polycondensation in an amount of at least 0.1 g/m². Further details are disclosed in EP-A-95203052.6.

In a preferred embodiment, the intermediate layer is a water-swellable intermediate layer coated at a ratio of 0.01 to 2.0 g/m2 and comprising at least one non-proteinic hydrophilic film-forming polymer e.g. polyvinyl alcohol and optionally comprising an antihalation dye or pigment as disclosed in EP-A-410500.

The non-proteinic hydrophilic film-forming polymer has to be chosen from the group of film-forming polymers that are soluble in aqueous medium and thus soften and swell by absorption of water. Suitable polymers are e. g. polyvinyl pyrrolidone, polyethylene oxide, partly hydrolyzed polyvinyl acetate, sulphonated polystyrene, hydroxyethyl cellulose, carboxymethyl cellulose, cellulose acetate hydrogen phthalate, dextran, dextrins or derivates thereof, starch, gum arabic, and alginic acid derivatives such as salts and esters thereof. It is also possible to use mixtures of two or more different non-proteinic hydrophilic film-forming polymers. Preference is given, however to polyvinyl alcohol or pullulan or a mixture thereof, more preferably for at least 50 % by weight , most preferably for at least 80% by weight of said non-proteinic hydrophilic film-forming polymer. In the case of a polyvinyl alcohol the ratio of alcohol and acetate units does not seem to play an important role.

Said preferred intermediate layer comprises preferentially for at least 90 %, more preferentially for at least 95 % of said non-proteinic hydrophilic film-forming polymer. Said preferred water swellable intermediate layer is coated at a thickness between 0.01 and 2.0 g/m², more preferably at a thickness between 0.07 and 0.3 g/m².

All said intermediate layers may comprise pigment particles with a number average diameter between 0.2 and 1 µm such as CaCO₃, TiO₂, BaSO₄, Al₂O₃, SiO₂, ZnO₂, etc..

The silver halide emulsion or emulsions according to the invention are preferentially substantially free from silver bromide. Substantially free from silver bromide means that said silver halide emulsion or emulsions comprises less than 0.1 mole % of silver bromide, preferably less than 0.01 mole % of silver bromide, most preferably is totally free from silver bromide.

The photosensitive layer used according to the present invention may be any layer comprising a hydrophilic colloid binder and at least one silver halide emulsion, at least one of the silver halide emulsions being photosensitive.

The photographic silver halide emulsion(s) used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

For use according to the present invention the silver halide emulsion or emulsions consist principally of silver chloride while a fraction of silver iodide may be present ranging from 0.01 mole % to 2 mole %. Preferably a silver halide emulsion containing at least 99 mole% of silver chloride is used.

The average size of the silver halide grains may range from 0.10 to 0.70 µm , preferably from 0.25 to 0.45 µm.

Preferably during the precipitation stage iridium and/or rhodium containing compounds or a mixture of both are added. The concentration of these added compounds ranges from 10⁻⁸ to 10⁻³ mole per mole of AgNO₃, preferably between 10⁻⁷ and 10⁻⁵ mole per mole of AgNO₃.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The silver halide emulsions of the DTR-element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

In the case of a conventional light source, e.g. tungsten light, a green sensitizing dye is needed. In case of exposure by an argon ion laser a blue sensizing dye is incorporated. In case of exposure by a red light emitting source, e.g. a LED or a HeNe laser a red sensitizing dye is used. In case of exposure by a semiconductor laser special spectral sensitizing dyes suited for the near infra-red are required. Suitable infra-red sensitizing dyes are disclosed in i.a. US-P 2,095,854, 2,095,856, 2,955,939, 3,482,978, 3,552,974, 3,573,921, 3,582,344, 3,623,881 and 3,695,888.

A preferred blue sensitizing dye, green sensitizing dye, red sensitizing dye and infra-red sensitizing dye in connection with the present invention are described in EP-A 554,585.

To enhance the sensitivity in the red or near infra-red region use can be made of so-called supersensitizers in combination with red or infra-red sensitizing dyes. Suitable supersensitizers are described in Research Disclosure Vol 289, May 1988, item 28952. The spectral sensitizers can be added to the photographic emulsions in the form of an aqueous solution, a solution in an organic solvent or in the form of a dispersion.

The silver halide emulsions may contain the usual emulsion stabilizers. Suitable emulsion stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable emulsion stabilizers are i.a. heterocyclic mercapto compounds.

As binder in the silver halide emulsion layer(s) in connection with the present invention a hydrophilic colloid may be used, usually a protein, preferably gelatin. Gelatin can, however, be replaced in part or integrally by synthetic, semi-synthetic, or natural polymers. Preferably the silver halide emulsion layer contains at least one gelatin species whereof a 10 % by weight aqueous solution at 36 °C and pH 6 has a viscosity lower than 20 mPas at a shearing rate of 1000 s⁻¹ combined with a gelatin of a higher viscosity. The weight ratio of said low viscosity gelatin versus the gelatin of a higher viscosity is preferably > 0.5.

Preferably the gelatin layer(s) is(are) substantially unhardened. Substantially unhardened means that when such gelatin layer is coated on a subbed polyethylene terephtalate film base at a dry thickness of 1.2 g/m², dried for 3 days at 57 C° and 35% R.H. and dipped in water of 30 C°, said gelatin layer is dissolved for more than 95 % by weight within 5 minutes.

The silver halide emulsions may contain pH controlling ingredients. Preferably at least one gelatin containing layer is coated at a pH value not below the iso-electric point of the gelatin to avoid interactions between said gelatin containing coated layer and the hereafter mentioned intermediate layer. More preferably the gelatin layer contiguous to said intermediate layer is coated at a pH value not below the iso-electric point of the gelatin. Most preferably all the gelatin containing layers are coated at a pH value not below the iso-electric point of their gelatin. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217.

More details about the composition, preparation and coating of silver halide emulsions suitable for use in accordance with the present invention can be found in e.g. Product Licensing Index, Vol. 92, December 1971, publication 9232, p. 107-109.

Preferably the imaging element comprises an antistress composition on top of the emulsion layer.

The antistress composition according to the invention comprises preferably unhardened gelatin in an amount ranging from 0.60 to 1.75 g/m², more preferably in an amount ranging from 0.80 to 1.25 g/m².

Preferably at least 50%, more preferably at least 75%, most preferably at least 90% by weight of said unhardened gelatin belongs to one or more gelatin species whereof a 10% by weight aqueous solution at 40°C and pH 6 has a viscosity lower than 20 mPas, more preferably lower than 15 mPas at a shearing rate of 1000 s⁻¹.

The antistress composition can comprises more than one species of unhardened gelatin whereof a 10% by weight aqueous solution at 40°C and pH 6 has a viscosity lower than 20 mPas at a shearing rate of 1000 s⁻¹, but it is preferred for practical reasons that said composition comprises only one such gelatin. When a mixture of unhardened gelatins is used, a 10% by weight aqueous solution of said mixture of unhardened gelatins has at 40°C and pH 6 preferably a viscosity lower than 20 mPas at a shearing rate of 1000 s⁻¹.

The antistress composition may contain small particles e.g. matting agents with a mean diameter between 0.2 and 10 µm in order to improve the diffusion of processing solutions through said antistress composition.

The antistress composition can comprise more than one layer, but for practical reasons it is preferred that said composition consist of one layer.

The antistress layer according to the invention has to be in water permeable relationship with said image receiving layer in the imaging element. Layers being in waterpermeable contact with each other are layers that are contiguous to each other or only separated from each other by (a) waterpermeable layer(s). The nature of a waterpermeable layer is such that it does not substantially inhibit or restrain the diffusion of water or of compounds contained in an aqueous solution e.g. developing agents or the complexed silver.

Said hydrophilic surface of a support can be a hardened hydrophilic layer, containing a hydrophilic binder and a hardening agent coated on a flexible support.

Such hydrophilic binders are disclosed in e.g. EP-A 450,199, which therefor is incorporated herein by reference. Preferred hardened hydrophilic layers comprise partially modified dextrans or pullulan hardened with an aldehyde as disclosed in e.g. EP-A 514,990 which therefor is incorporated herein by reference. More preferred hydrophilic layers are layers of polyvinyl alcohol hardened with a tetraalkyl orthosilicate and preferably containing SiO₂ and/or TiO₂ wherein the weight ratio between said polyvinylalcohol and said tetraalkyl orthosilicate is between 0.5 and 5 as disclosed in e.g. GB-P 1,419,512, FR-P 2,300,354, US-P-3,971,660, US-P 4,284,705, EP-A 405,016 and EP-A 450,199 which therefor are incorporated herein by reference.

Flexible supports may be opaque or transparent, e.g. a paper support or resin support. When a paper support is used preference is given to one coated at one or both sides with an Alpha-olefin polymer. It is also possible to use an organic resin support e.g. poly(ethylene terephthalate) film or poly-Alpha-olefin films. The thickness of such organic resin film is preferably comprised between 0.07 and 0.35 mm. These organic resin supports are preferably coated with a hydrophilic adhesion layer which can contain water insoluble particles such as silica or titanium dioxide.

Said hydrophilic surface of a support is preferably a hydrophilic metallic support e.g. an aluminum foil.

The aluminum support of the imaging element for use in accordance with the present invention can be made of pure aluminum or of an aluminum alloy, the aluminum content of which is at least 95%. The thickness of the support usually ranges from about 0.13 to about 0.50 mm.

The preparation of aluminum or aluminum alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improve the printing results. Preferably the aluminum support has 500 or more pits per 100 µm², diameters of the pits being 0.03 to 0.30 µm and an average diameter of the pits being 0.05 to 0.20µm. Preferably the aluminum foil has a roughness with a CLA value between 0.2 and 1.5 µm, an anodization layer with a thickness between 0.4 and 2.0 µm and is posttreated with an aqueous bicarbonate solution.

According to the present invention the roughening of the aluminum foil can be performed according to the methods well known in the prior art. The surface of the aluminum substrate can be roughened either by mechanical, chemical or electrochemical graining or by a combination of these to obtain a satisfactory adhesiveness of a silver halide emulsion layer to the aluminum support and to provide a good water retention property to the areas that will form the non-printing areas on the plate surface.

The electrochemical graining process is preferred because it can form a uniform surface roughness having a large average surface area with a very fine and even grain which is commonly desired when used for lithographic printing plates.

The roughening is preferably preceded by a degreasing treatment mainly for removing fetty substances from the surface of the aluminum foil.

Therefore the aluminum foil may be subjected to a degreasing treatment with a surfactant and/or an aqueous alkaline solution.

Preferably roughening is followed by a chemical etching step using an aqueous solution containing an acid. The chemical etching is preferably carried out at a temperature of at least 30°C more preferably at least 40°C and most preferably at least 50°C.

After roughening and optional chemical etching the aluminum foil is anodized which may be carried out as follows.

An electric current is passed through the grained aluminum foil immersed as an anode in a solution containing an acid. An electrolyte concentration from 1 to 70 % by weight can be used within a temperature range from 0-70°C. The anodic current density may vary from 1-50 A/dm² and a voltage within the range 1-100 V to obtain an anodized film weight of 1-8 g/m² Al₂O₃.H₂O. The anodized aluminum foil may subsequently be rinsed with demineralised water within a temperature range of 10-80°C.

After the anodizing step sealing may be applied to the anodic surface. Sealing of the pores of the aluminum oxide layer formed by anodization is a technique known to those skilled in the art of aluminum anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminium". Different types of sealing of the porous anodized aluminum surface exist.

Preferably, said sealing is performed by treating a grained and anodized aluminum support with an aqueous solution containing a bicarbonate as disclosed in EP-A 567178, which therefor is incorporated herein by reference or by treating with a solution of polyvinyl phosphonic acid.

Preferably each of the above described steps is separated by a rinsing step to avoid contamination of the liquid used in a particular step with that of the preceding step.

To promote the image sharpness and, as a consequence thereof, the sharpness of the final printed copy, the anodization layer may be coloured in the mass with an antihalation dye or pigment e.g. as described in JA-Pu-58-14,797.

Subsequent to the preparation of the hydrophilic layer of a support as described above, said hydrophilic layer may be immediately coated with a solution containing the physical development nuclei or may be coated with said solution at a later stage.

The image receiving layer preferably comprises physical development nuclei in an amount ranging from 0.1 mg to 20 mg/m², more preferably in an amount from 0.5 to 5 mg/m². The image receiving layer containing physical development nuclei may be free of hydrophilic binder but preferably comprises small amounts upto 80% by weight of the total weight of said layer of a hydrophilic colloid e.g. polyvinyl alcohol or polyvinyl acrylic acid to improve the hydrophilicity of the surface.

Preferred development nuclei for use in accordance with the present invention are sulphides of heavy metals e.g. sulphides of antimony, bismuth, cadmium, cobalt, lead, nickel, palladium, platinum, silver, and zinc. Other suitable development nuclei are salts such as e.g. selenides, polyselenides, polysulphides, mercaptans, and tin (II) halides. Heavy metals, preferably silver, gold, platinum, palladium, and mercury can be used in colloidal form. Especially suitable development nuclei in connection with the present invention are palladium sulphide nuclei and colloidal silver.

The imaging element is preferably prepared by coating the different layers on a hydrophilic surface of a support. Alternatively the different layers may be laminated to said image receiving layer from a temporary base holding the layers in reverse order as disclosed in US-P 5,068,165.

The coating of the different layers is preferably performed as follows.

On a hydrophilic surface of a support coated with a layer of physical development nuclei is coated in one multilayer slide coating in the order given an intermediate layer, a silver halide emulsion layer and optionally an antistress layer.

The intermediate layer is preferably coated at a wet thickness between 3 and 15 µm, preferably between 5 and 10 µm. The coating solution for said layer preferably contains a nonylphenoxy terminated polyethylene oxide (AKYPO-OP-80, trade mark for a surfactant sold by Chemische Fabrik Chem-Y, Gmbh, Germany) as surfactant in an amount between 0.25 and 0.75 g/l. The viscosity of the coating solution for said layer lies preferably between 1.5 and 6 mPas, more preferably between 2 and 4 mPas and the surface tension preferably between 27 and 50 mN/m, more preferably between 30 and 40 mN/m.

The silver halide emulsion layer is preferably coated at a wet thickness between 15 and 40 µm, more preferably between 20 and 30 µm. Said layer comprises preferably between 0.5 and 2.5 g, more preferably between 1.0 and 1.8 g of gelatine/m² and preferably between 1 and 4 g, more preferably between 1.50 and 2.80 g of silver halide (expressed as silver nitrate)/m². The viscosity of the coating solution for said layer lies preferably between 2 and 10 mPas, more preferably 3 and 7 mPas.

The optional antistress layer is preferably coated at a wet thickness in the range of 5 to 15, more preferably between 7 to 13 µm. The coating solution for said layer preferably contains as surfactants a nonylphenoxy terminated polyethylene oxide (AKYPO-OP-80) in an amount between 0.25 and 0.75 g/l and an anionic perfluorsurfactant (FT 248 trade mark for a surfactant sold by Bayer A.G., Germany in an amount between 0.25 and 0.75 g/l. The viscosity of the coating solution for said layer lies preferably between 2 and 12 mPas, more preferably between 4 and 8 mPas and the surface tension preferably between 22 and 40 mN/m, more preferably between 25 and 30 mN/m.

The total thickness of the wet multilayer package lies preferably between 20 and 80 µm, more preferably between 30 and 60 µm and said multilayer slide coating is preferably performed at a rate between 40 and 150 m/min., more preferably at a rate between 50 and 120 m/min..

A supplemental intermediate layer, which may be present between said silver halide emulsion containing layer and said intermediate layer may incorporate one or more ingredients such as i.a. antihalation dyes or pigments, developing agents, silver halide solvents, base precursors, and anticorrosion substances.

When the imaging element is prepared by laminating a layer packet comprising a photosensitive layer onto the image receiving layer the intermediate layer(s) are provided on the photosensitive layer(s), the intermediate layer being the upper layer.

According to the present invention the imaging element can be information-wise exposed in an apparatus according to its particular application. A wide choice of cameras for exposing the photosensitive silver halide emulsion exists on the market. Horizontal, vertical and darkroom type cameras and contact-exposure apparatus are available to suit any particular class of reprographic work. The imaging element in accordance with the present invention can also be exposed with the aid of i.a. laser recorders and cathode rays tubes.

According to the present invention the development and diffusion transfer of the information-wise exposed imaging element in order to form a silver image in said photosensitive layer and to allow unreduced silver halide or complexes formed thereof to diffuse image-wise from the photosensitive layer to said image receiving layer to produce therein a silver image, are effected with the aid of an aqueous alkaline solution in the presence of at least a developing agent, and at least a silver halide solvent. The developing agent(s) and/or the silver halide solvent(s) can be incorporated in the aqueous alkaline solution and/or in the imaging element.

Preferably a silver halide solvent in the aqueous alkaline solution is used in an amount between 0.05% by weight and 5% by weight and more preferably between 0.5% by weight and 2% by weight. The silver halide solvent, which acts as a complexing agent for silver halide, preferably is a water-soluble thiosulphate or thiocyanate e.g. sodium, potassium, or ammonium thiosulphate and sodium, potassium, or ammonium thiocyanate.

Further silver halide solvents that can be used in connection with the present invention are e.g. sulphite, amines, 2-mercaptobenzoic acid, cyclic imide compounds such as e.g. uracil, 5,5-dialkylhydantoins, alkyl sulfones and oxazolidones.

Further preferred silver halide solvents for use in connection with the present invention are alkanolamines. Examples of alkanolamines that may be used in connection with the present invention correspond to the following formula: 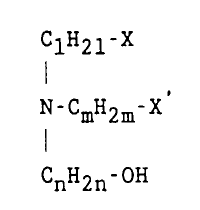 wherein X and X' independently represent hydrogen, a hydroxyl group or an amino group, 1 and m represent 0 or integers of 1 or more and n represents an integer of 1 or more. Said alkanolamines may be present in the alkaline processing liquid in a concentration preferably between 0.1% and 5% by weight. However part or all of the alkanolamine can be present in one or more layers of the imaging element.

Still other preferred further silver halide solvents for use in connection with the present invention are thioethers. Preferably used thioethers correspond to the following general formula:

Z-(R¹-S)ₜ-R²-S-R³-Y

wherein Z and Y each independently represents hydrogen, an alkyl group, an amino group, an ammonium group, a hydroxyl, a sulfo group, a carboxyl, an aminocarbonyl or an aminosulfonyl, R¹, R² and R³ each independently represents an alkylene that may be substituted and optionally contain an oxygen bridge and t represents an integer from 0 to 10. Examples of thioether compounds corresponding to the above formula are disclosed in e.g. US-P-4.960.683 and EP-A 554,585.

Still further suitable silver halide solvents are 1,2,4-triazolium-3-thiolates, preferably 1,2,4-triazolium-3-thiolates substituted with at least one substituent selected from the group consisting of a C₁-C₈ alkyl group that contains at least 3 fluorine atoms, a C₄-C₁₀ hydrocarbon group and a 4-amino group substituted with a C₁-C₈ alkyl group that contains at least 3 fluorine atoms and/or a C₄-C₁₀ hydrocarbon group.

Combinations of different silver halide solvents can be used and it is also possible to incorporate at least one silver halide solvent into a suitable layer of the imaging element and to add at least one other silver halide solvent to the developing solution.

The alkaline processing liquid may also contain (a) developing agent(s). In this case the alkaline processing liquid is called a developer. On the other hand some or all of the developing agent(s) may be present in one or more layers of the photographic material or imaging element. When all of the developing agents are contained in the imaging element the alkaline processing liquid is called an activator or activating liquid.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidone-type developing agent and/or p-monomethylaminophenol. Particularly useful auxiliary developing agents are the 1-phenyl-3-pyrazolidones. Even more preferred, particularly when they are incorporated into the photographic material are 1-phenyl-3-pyrazolidones of which the aqueous solubility is increased by a hydrophilic substituent such as e.g. hydroxy, amino, carboxylic acid group, sulphonic acid group etc.. Examples of 1-phenyl-3-pyrazolidones subsituted with one or more hydrophilic groups are e.g. 1-phenyl-4,4-dimethyl-2-hydroxy-3-pyrazolidone. 1-(4-carboxyphenyl)-4,4-dimethyl-3-pyrazolidone etc.. However other developing agents can be used.

Preferred amounts of the hydroquinone-type developing agents are in the range of 0.05 mole to 0.40 mole per litre and preferred amounts of secondary developing agent(s) in the range of 1.8 x 10⁻³ to 2.0 x 10⁻¹ mole per litre.

The aqueous alkaline solution in accordance with the present invention may further comprise sulphite e.g. sodium sulphite in an amount ranging from 40 g to 180 g per liter, preferably from 60 to 160 g per liter in combination with another silver halide solvent.

The quantitative ranges given for the developing agents, silver halide solvents, and sulphite apply to the amount of these compounds present as solutes in the aqueous alkaline solution during the DTR-processing, whether these compounds make part of the aqueous alkaline solution or were dissolved from the layers containing them upon application thereto of the aqueous alkaline solution.

The aqueous alkaline solution suitable for use according to the present invention preferably comprises aluminum ions in an amount of at least 0.3 g/l, more preferably in an amount of at least 0.6 g/l in order to prevent sticking of the emulsion layer to the transporting rollers when the emulsion is swollen with the aqueous alkaline solution.

The alkaline processing liquid preferably has a pH between 9 and 14 and more preferably between 10 and 13, but depends on the type of silver halide emulsion material to be developed, intended development time, and processing temperature.

The processing conditions such as temperature and time may vary within broad ranges provided the mechanical strength of the materials to be processed is not adversely influenced and no decomposition takes place.

The pH of the alkaline processing liquid may be established by an organic or inorganic alkaline substance or a combination thereof. Suitable inorganic alkaline substances are e.g. hydroxides of sodium and potassium, alkali metal salts of phosphoric acid and/or silicic acid e.g. trisodium phosphate, orthosilicates, metasilicates, hydrodisilicates of sodium or potassium, and sodium carbonate etc.. Suitable organic alkaline substances are e.g. alkanolamines. In the latter case the alkanolamines will provide or help providing the pH and serve as a silver halide complexing agent.

The aqueous alkaline solution may further comprise hydrophobizing agents for improving the hydrophobicity of the silver image obtained in the image receiving layer. Generally these compounds contain a mercapto group or thiolate group and one or more hydrophobic substituents. Particularly preferred hydrophobizing agents are mercapto-1,3,4-thiadiazoles as described in DE-A 1,228,927 and in US-P 4,563,410, 2-mercapto-5-alkyl-oxa-3,4-diazole, 3-mercapto-5-alkyl-1,2,4-triazoles and long chain (at least 5 carbon atoms) alkyl substituted mercaptotetrazoles. The hydrophobizing agents can be used alone or in combination with each other.

These hydrophobizing compounds can be added to the aqueous alkaline solution in an amount of preferably 0.1 to 3 g per litre and preferably in admixture with 1-phenyl-5-mercaptotetrazole, the latter compound may be used in amounts of e.g. 50 mg to 1.2 g per litre of solution, which may contain a minor amount of ethanol to improve the dissolution of said compounds.

The aqueous alkaline solution may comprise other ingredients such as e.g. oxidation preservatives, calcium-sequestering compounds, anti-sludge agents, and hardeners including latent hardeners.

Regeneration of the aqueous alkaline solution according to known methods is, of course, possible, whether the solution incorporates developing agent(s) and/or silver halide solvent(s) or not.

The development may be stopped - though this is often not necessary - with a so-called stabilization liquid, which actually is an acidic stop-bath having a pH preferably in the range from 5 to 7.

Bufferred stop bath compositions comprising a mixture of sodium dihydrogen orthophosphate and disodium hydrogen orthophosphate and having a pH in said range are preferred.

The development and diffusion transfer can be initiated in different ways e.g. by rubbing with a roller, by wiping with an absorbent means e.g. with a plug of cotton or sponge, or by dipping the material to be treated in the liquid composition. Preferably, they proceed in an automatically operated apparatus. They are normally carried out at a temperature in the range of 18°C to 30°C and in a time from 5 s to 5 min.

After formation of the silver image on the hydrophilic surface of a support an excess of aqueous alkaline solution still present on the base may be eliminated, preferably by guiding the foil through a pair of squeezing rollers.

The silver image thus obtained in the layer of physical development nuclei is subsequently uncovered by treating the imaging element to remove all the layers above the layer containing physical development nuclei, thereby exposing the imaged surface of the hydrophilic support.

According to a particularly preferred embodiment of the present invention the silver image in the layer of physical development nuclei is uncovered by washing off all the layers above the layer containing physical development nuclei with rinsing water.

The temperature of the rinsing water may be varied widely but is preferably between 30 °C and 50 °C, more preferably between 35°C and 45°C.

The imaged surface of the hydrophilic surface of a support can be subjected to a chemical treatment that increases the hydrophilicity of the non-silver image parts and the oleophilicity of the silver image

This chemical after-treatment is preferably carried out with a lithographic composition often called finisher comprising at least one compound enhancing the ink-receptivity and/or lacquer-receptivity of the silver image and at least one compound that improves the ink-repelling characteristics of the hydrophilic surface.

Suitable ingredients for the finisher are e.g. organic compounds containing a mercapto group such as the hydrophobizing compounds referred to hereinbefore for the alkaline solution. Preferred compounds correspond to one of the following formulas: 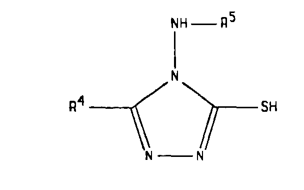 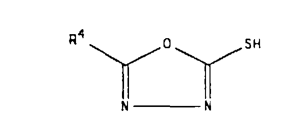 wherein R⁵ represents hydrogen or an acyl group, R⁴ represents alkyl, aryl or aralkyl. Most preferably used compounds are compounds according to one of the above formulas wherein R⁴ represents an alkyl containing 3 to 16 C-atoms. Said (a) hydrophobizing agent(s) is(are) comprised in the finisher preferably in a total concentration between 0.1 g/l and 10 g/l, more preferably in a total concentration between 0.3 g/l and 3 g/l.

Additives improving the oleophilic ink-repellency of the hydrophilic surface areas are e.g. carbohydrates such as acidic polysaccharides like gum arabic, carboxymethylcellulose, sodium alginate, propylene glycol ester of alginic acid, hydroxyethyl starch, dextrin, hydroxyethylcellulose, polyvinyl pyrrolidone, polystyrene sulphonic acid, polyglycols being the reaction products of ethyleneoxide and/or propyleneoxide with water or an alcohol and polyvinyl alcohol. Optionally, hygroscopic substances e.g. sorbitol, glycerol, tri(hydroxyethyl)ester of glycerol, and turkish red oil may be added.

Furthermore (a) surface-active compound(s) is (are) preferably also added to the finisher. The concentration thereof may vary within broad ranges provided the finisher shows no excessive degree of foaming when plates are finished. Preferred surface-active compound are anionic or non-ionic surface-active compound.

A suitable finisher as disclosed in US-A-4.563.410 is a composition comprising a solution of a mercaptotriazole in a solution of polyethylene oxide with a molecular weight of 4,000. Further suitable finishers have been described in i.a. US-A 4.062.682.

At the moment the treatment with the finisher is started the surface carrying the silver pattern may be in dry or wet state. In general, the treatment with the finisher does not take long, usually not longer than about 30 seconds and it may be carried out immediately after the processing and uncovering steps, preferably at a temperature of the finisher in the range from 30°C to 60°C.

The finisher can be applied in different ways such as by rubbing with a roller, by wiping with an absorbent means e.g. with a plug of cotton or sponge, or by dipping the material to be treated in the finisher. The image-hydrophobizing step of the printing plate may also proceed automatically by conducting the printing plate through a device having a narrow channel filled with the finisher and conveying the printing plate at the end of the channel between two squeezing rollers removing the excess of liquid.

As soon as the hydrophilic surface of a support carrying the silver image has been treated with the finisher, it is ready to be used as a printing plate.

The following example illustrates the present invention without however, limiting it thereto. All parts, percentages and ratios are by weight unless otherwise indicated.

### EXAMPLE 1

A 0,30 mm thick aluminium foil (AA 1050) was degreased by immersing the foil in an aqueous solution containing 10 % phosphoric acid and subsequently etched in an aqueous solution containing 2 g/l of sodium hydroxide. The foil was then electrochemically grained using an alternating current in an aqueous solution containing 4 g/l of hydrochloric acid and 4 g/l of hydroboric acid at a temperature of 35°C to form a surface topography with an average center-line roughness Ra of 0,6 µm. The aluminium plate was then desmutted with an aqueous solution containing 30 % of sulfuric acid at 60°C for 120 seconds. The foil was subsequently subjected to anodic oxidation in a 20 % sulfuric acid aqueous solution to form an anodic oxidation film of 3.0 g/m² of Al₂O₃.H₂O, treated with an aqueous solution containing 20 g/l of NaHCO₃ at 45°C for 30 sec and then rinsed with demineralised water and dried.

The imaging element I was obtained by coating the grained, anodized and posttreated aluminum support with a silver-receptive stratum containing 1.1 mg/m² PdS as physical development nuclei.

An intermediate layer was then provided on the dry silver-receptive stratum from an aqueous composition in such a way that the resulting dried layer had a weight of 0.1 g of pullulan

Subsequently a substantially unhardened photosensitive negative-working cadmium-free gelatin silver chloroiodide emulsion layer (97.75 / 0.25 mol%) containing 1 mmole/mole AgX of 4-hydroxy-6-methyl-1,3,3a,7-tetraazaindene and 2.2 mole/ mole AgX of 1-(3-(2-sulphobenzamido))phenyl-5-mercapto-tetrazole was coated on the intermediate layer, the silver halide being provided in an amount corresponding to 1.80 g of silver nitrate per m² and the gelatin content of the emulsion layer being 1.58 g/m², consisting of 0.7 g/m² of a gelatin with a viscosity of 21 mPas and the remainder of a gelatin with a viscosity of 14 mPas.

Finally the photosensitive emulsion layer was overcoated with an antistress layer containing no hardeners comprising 0.7 g/m² gelatin with a viscosity of 10-12 mPas ( gelatin K 7598 of Koepff.)

Imaging elements II, III and IV were prepared in an identical way as imaging element I with the exception that the intermediate layer contained respectively 5 mg, 10 mg and 20 mg KBr per m².

Imaging elements V, VI and VII were prepared in an identical way as imaging element I with the exception that the emulsion layer contained respectively 5 mg, 10 mg and 20 mg KBr per m².

The seven obtained unexposed imaging elements were immersed for 10 s at 24°C in a freshly made developing solution having the following composition:

| | |
|---|---|
| carboxymethylcellulose | 4 g |
| sodium hydroxide | 22.5 g |
| anhydrous sodium sulphite | 120 g |
| hydroquinone | 20 g |
| 1-phenyl-4-methyl-3-pyrazolidinone | 6 g |
| aminoethyl-aminoethanol | 1 ml |
| ethylene diamine tetraacetic acid tetrasodium salt | 2 g |
| aluminum sulfate. 18 aq | 8.4 g |
| demineralized water to make | 1000 ml |
| pH (24°C) = 13 | |

The initiated diffusion transfer was allowed to continue for 20 s to form a silver image in the image receiving layers.

To remove the developed silver halide emulsion layer and the intermediate layer from the aluminium foil the developed monosheet DTR materials were rinsed for 5 s with a water jet at 40°C in a LP 82 (tradename of a processor marketed by Agfa-Gevaert, Belgium).

Next, the imaged surfaces of the aluminium foils were treated in a LP 82 (marketed by Agfa-Gevaert, N.V. of Belgium) for 15 s with a finisher at 45 °C to enhance the water-receptivity of the non-image areas and to make the image areas oleophilic ink-receptive. The finisher had the following composition :

| | |
|---|---|
| Gebo ( trade mark for a surfactant sold by Chemische Fabrik Chem-Y, Gmbh, Germany) | 250 mg |
| polyethylene glycol 3000 | 100 ml |
| potassium nitrate | 12.5 g |
| citric acid | 20.0 g |
| 2-mercapto-5-heptyl-oxa-3,4-diazole | 2.0 g |
| NaH₂PO₄.2H₂O | 20.0 g |
| 5-bromo-5-nitro-1,3-dioxane | 200 mg |
| sodium hydroxyde | 13.0 g |
| water to make | 1000 ml |
| pH (20°C) = 5.9 | |

The obtained printing plates where then used for printing on a conventional printing press with a conventional printing ink and a conventional fountain. The ink acceptance of the 25^{th} print was then qualitatively evaluated on a scale from 0 to 3 where o stands for an excellent ink acceptance and 3 for a very poor ink acceptance. The results are given in table 1.

**Table 1**

| Imaging element | Ink Acceptance |
|---|---|
| I | 3 |
| II | 1.5 |
| III | 0.5 |
| IV | 0 |
| V | 2.5 |
| VI | 1.5 |
| VII | 1.5 |

It is clear from the results in table 1 that imaging elements having less than 10 mg KBr/m² ( less than 0.08 mmol bromide/m²) in the intermediate layer yield printing plates having a bad to a very bad ink acceptance (comparison elements I, II, V, VI and VII) while imaging elements having 10 mg KBr/m² (0.083 mmole bromide/m²) in the intermediate layer yields a printing plate with a good printing acceptance (element according to the invention III) and an imaging element having 20 mg/m² of KBr in the intermediate layer yields a printing plate with an excellent ink acceptance (element according to the invention IV).

## Claims

1. An imaging element comprising in the order given on a hydrophilic surface of a support (i) an image receiving layer containing physical development nuclei, (ii) an intermediate layer and (iii) a photosensitive layer containing one or more silver halide emulsions being in water permeable relationship with said image receiving layer, characterized in that said intermediate layer comprises at least 0.08 mmole/m² of a bromide salt.

2. An imaging element according to claim 1 wherein said intermediate layer comprises at least 12 mmole/m² of bromide salt.

3. An imaging element according to claim 1 or 2 wherein said intermediate layer comprises for at least 70 % of its weight one or more non-proteinic hydrophilic film forming polymers.

4. An imaging element according to claim 3 wherein the weight of said intermediate layer ranges between 0.01 and 2 g/m².

5. An imaging element according to any of claims 3 or 4 wherein said intermediate layer comprises polyvinyl alcohol or pullulan or a mixture thereof for at least 50 % by weight of said non-proteinic hydrophilic film-forming polymer.

6. An imaging element according to any of claims 1 to 5 wherein said silver halide emulsion comprises at least 99 mole % of silver chloride.

7. An imaging element according to any of claims 1 to 6 wherein said imaging element comprises an antistress layer on top of said emulsion layer and in water permeable relationship therewith.

8. An imaging element according to any of claims 1 to 7 wherein said antistress layer comprises unhardened gelatin in an amount ranging from 0.60 to 1.75 g/m².

9. A method for making an offset printing plate according to the silver salt diffusion transfer process comprising the steps of:
(a) image-wise exposing an imaging element according to any of claims 1 to 9,
(b) applying an aqueous alkaline solution to the imaging element in the presence of at least one developing agent and at least one silver halide solvent,
(c) treating the imaging element to remove the layer(s) on top of said image receiving layer, thereby uncovering said silver image formed in said image receiving layer.

10. A method for making an offset printing plate according to the silver salt diffusion transfer process according to claim 9 wherein at least one silver halide solvent is an alkanolamine.

## Patentansprüche

1. Ein bilderzeugendes Element, das der angegebenen Reihe nach auf einer hydrophilen Oberfläche eines Trägers (i) eine physikalische Entwicklungskeime enthaltende Bildempfangsschicht, (ii) eine Zwischenschicht und (iii) eine lichtempfindliche Schicht mit einer oder mehreren Silberhalogenidemulsionen in wasserdurchlässiger Beziehung zur Bildempfangsschicht enthält, dadurch gekennzeichnet, daß die Zwischenschicht wenigstens 0,08 Mmol/m² eines Bromidsalzes enthält.

2. Bilderzeugendes Element nach Anspruch 1, dadurch gekennzeichnet, daß die Zwischenschicht wenigstens 12 Mmol/m² Bromidsalz enthält.

3. Bilderzeugendes Element nach Anspruch 1 oder 2, dadurch gekennzeichnet, daß die Zwischenschicht in einem Verhältnis von wenigstens 70%, bezogen auf ihr Gewicht, ein oder mehrere nichtproteinhaltige hydrophile filmbildende Polymere enthält.

4. Bilderzeugendes Element nach Anspruch 3, dadurch gekennzeichnet, daß das Gewicht der Zwischenschicht zwischen 0,01 und 2 g/m² liegt.

5. Bilderzeugendes Element nach irgendeinem der Ansprüche 3 oder 4, dadurch gekennzeichnet, daß die Zwischenschicht in einem Gewichtsverhältnis von wenigstens 50%, bezogen aus das nichtproteinhaltige hydrophile filmbildende Polymere, Polyvinylalkohol oder Pullulan oder ein Gemisch derselben enthält.

6. Bilderzeugendes Element nach irgendeinem der Ansprüche 1 bis 5, dadurch gekennzeichnet, daß die Silberhalogenidemulsion wenigstens 99 mol-% Silberchlorid enthält.

7. Bilderzeugendes Element nach irgendeinem der Ansprüche 1 bis 6, dadurch gekennzeichnet, daß das bilderzeugende Element auf der Emulsionsschicht und in wasserdurchlässiger Beziehung dazu eine Schutzschicht enthält.

8. Bilderzeugendes Element nach irgendeinem der Ansprüche 1 bis 7, dadurch gekennzeichnet, daß die Schutzschicht ungehärtete Gelatine in einer Menge zwischen 0,60 und 1,75 g/m² enthält.

9. Ein Verfahren zur Herstellung einer Offsetdruckplatte nach dem Silbersalz-Diffusionsübertragungsverfahren, das folgende Stufen umfaßt :
(a) die bildmäßige Belichtung eines nach irgendwelchem der Ansprüche 1 bis 9 definierten bilderzeugenden Elements,
(b) den Auftrag einer wäßrigen alkalischen Lösung auf das bilderzeugende Element in Gegenwart einer oder mehrerer Entwicklersubstanzen und eines oder mehrerer Silberhalogenid-Lösungsmittel,
(c) die Verarbeitung des bilderzeugenden Elements zur Entfernung der auf der Bildempfangsschicht befindlichen Schicht(en), wodurch das in der Bildempfangsschicht erzeugte Silberbild freigelegt wird.

10. Verfahren zur Herstellung einer Offsetdruckplatte nach dem Silbersalz-Diffusionsübertragungsverfahren nach Anspruch 9, dadurch gekennzeichnet, daß wenigstens ein Silberhalogenid-Lösungsmittel ein Alkanolamin ist.

## Revendications

1. Elément formateur d'images comprenant, dans l'ordre indiqué, sur une surface hydrophile d'un support, (i) une couche réceptrice d'images contenant des germes de développement physique, (ii) une couche intermédiaire et (iii) une couche photosensible contenant une ou plusieurs émulsions aux halogénures d'argent en relation de perméabilité à l'eau avec ladite couche réceptrice d'images, caractérisé en ce que ladite couche intermédiaire comprend au moins 0,08 mmole/m² d'un sel de bromure.

2. Elément formateur d'images selon la revendication 1 caractérisé en ce que ladite couche intermédiaire comprend au moins 12 mmole/m² de sel de bromure.

3. Elément formateur d'images selon la revendication 1 ou 2 caractérisé en ce que ladite couche intermédiaire se compose pour au moins 70% en poids d'un ou de plusieurs polymères filmogènes hydrophiles non protéiniques.

4. Elément formateur d'images selon la revendication 3 caractérisé en ce que le poids de ladite couche intermédiaire varie entre 0,01 et 2 g/m².

5. Elément formateur d'images selon la revendication 3 ou 4 caractérisé en ce que ladite couche intermédiaire comprend de l'alcool polyvinylique ou de la pullulane ou un mélange de ces substances à raison d'au moins 50% en poids par rapport audit polymère filmogène hydrophile non protéinique.

6. Elément formateur d'images selon l'une quelconque des revendications 1 à 5 caractérisé en ce que ladite émulsion aux halogénures d'argent comprend au moins 99 moles % de chlorure d'argent.

7. Elément formateur d'images selon l'une quelconque des revendications 1 à 6 caractérisé en ce que ledit élément formateur d'images comprend une couche protectrice au-dessus de ladite couche d'émulsion et en relation de perméabilité à l'eau avec celle-là.

8. Elément formateur d'images selon l'une quelconque des revendications 1 à 7 caractérisé en ce que ladite couche protectrice comprend de la gelatine non durcie dans une quantité dans le domaine de 0,60 à 1,75 g/m².

9. Procédé de confection de clichés d'impression offset conformément au procédé de transfert de sels d'argent par diffusion, comprenant les étapes consistant à:
(a) exposer en forme d'image un élément formateur d'images selon l'une quelconque des revendications 1 à 9,
(b) appliquer une solution alcaline aqueuse sur l'élément formateur d'images en présence d'au moins un agent développateur et d'au moins un solvant pour l'halogénure d'argent,
(c) traiter l'élément formateur d'images pour éliminer la ou les couches appliquées au-dessus de ladite couche réceptrice d'images pour ainsi mettre à nu l'image argentique formée dans ladite couche réceptrice d'images.

10. Procédé de confection de clichés d'impression offset conformément au procédé de transfert de sels d'argent par diffusion, selon la revendication 9 caractérisé en ce qu'au moins un solvant pour l'halogénure d'argent est une alcanolamine.
